# EUROPEAN PATENT SPECIFICATION

(11) **EP 0 744 769 B1**
(45) Date of publication and mention of the grant of the patent: **27.11.2002**
(21) Application number: 96107826.8
(22) Date of filing: 16.05.1996
(51) Int. Cl.: H01L 21/331

(54) **Method of manufacturing MOS gate type power transistors**
Verfahren zur Herstellung von MOS-Leistungstransistoren
Méthode de fabrication de transistors de puissance à porte MOS

(30) Priority: 22.05.1995 KR 9512803
(43) Date of publication of application: 27.11.1996
(73) Proprietor: SAMSUNG ELECTRONICS CO., LTD., Suwon-city, Kyungki-do 441-373 (KR)
(72) Inventor: Han, Min-Koo, Kangnam-gu, Seoul (KR); Yun, Chong-Man, Youngdeungpo-gu, Seoul (KR); Choi, Yearn-Ik, Seocho-gu, Seoul (KR)
(74) Representative: Tunstall, Christopher Stephen

(56) References cited:
- EP-A- 0 342 952
- US-A- 5 079 602
- PREUSSGER A: "SPT - A NEW SMART POWER TECHNOLOGY WITH A FULLY SELF ALIGNED DMOS CELL" PROCEEDINGS OF THE INTERNATIONAL SYMPOSIUM ON POWER SEMICONDUCTOR DEVICES AND IC'S, BALTIMORE, APRIL 22 - 24, 1991, no. SYMP. 3, 22 April 1991, pages 195-197, XP000218979 AYMAN SHIBIB;JAYANT BALIGA
- DISNEY D R ET AL: "SOI LIGBT DEVICES WITH A DUAL P-WELL IMPLANT FOR IMPROVED LATCHING CHARACTERISTICS" PROCEEDINGS OF THE INTERNATIONAL SYMPOSIUM ON POWER SEMICONDUCTOR DEVICES AND IC'S (ISPSD), MONTEREY, MAY 18 - 20, 1993, no. SYMP. 5, 18 May 1993, pages 254-258, XP000380157 WILLIAMS R K;JAYANT BALIGA B
- LASKA T ET AL: "A LOW LOSS/HIGHLY RUGGED IGBT-GENERATION-BASED ON A SELF ALIGNED PROCESS WITH DOUBLE IMPLANTED N/N+-EMITTER" PROCEEDINGS OF THE INTERNATIONAL SYMPOSIUM ON POWER SEMICONDUCTOR DEVICES (ISPSD), DAVOS, CH, MAY 31 - JUNE 2, 1994, no. SYMP. 6, 31 May 1994, pages 171-175, XP000505815 FICHTNER W (ED )
- YUN C -M ET AL: "A SELF-ALIGNED LATCH-FREE IGBT WITH SIDEWALL DIFFUSED N+ EMITTER" PROCEEDINGS OF THE 7TH. INTERNATIONAL SYMPOSIUM ON POWER SEMICONDUCTOR DEVICES AND IC'S. (ISPSD), YOKOHAMA, MAY 23 - 25, 1995, no. SYMP. 7, 23 May 1995, pages 196-200, XP000594257 INSTITUTE OF ELECTRICAL AND ELECTRONICS ENGINEERS

## Description

The present invention relates to the manufacture of a MOS gate type power transistor, and more particularly, of a trench body structure for a MOS gate type power transistor.

Generally, high latch-up current density and low forward voltage drop are important device characteristics to be taken into account in designing a PNPN structure MOS gate type power transistor which has a large handling current density and high switching speed characteristics. To obtain the low forward voltage drop, it is desirable to increase the current density in a component and to increase the current density, the size of the component unit cell should be reduced.

The size of the cell depends upon a P' body and a junction field effect transistor (JFET) region. In the JFET region, owing to generation of the forward voltage drop from anode to cathode, the size of the cell cannot be reduced below a given size. The foregoing is disclosed in "Modern Power Devices", Wiley, 1987. Further, in the P⁻ body, with little contribution to current conduction, the size of the cell should be reduced as much as possible. Furthermore, when errors in the photographic process for forming the N' source, channel and cathode contact are taken into account, the P⁻ body has to be increased.

It is the emitter efficiency of an NPN transistor that determines the latch characteristic of the MOS gate type power transistor. Herein, the NPN transistor comprises a P⁻ body resistance at a lower portion of the N⁻ source and N⁺ source/P⁻ body/N⁻ epitaxial layer at an upper portion. This is disclosed in a paper entitled "A Low Loss/Highly Rugged IGBT-Generation-Based on a Self Aligned Process with Double Implanted N/N⁻-Emitter", Proc. ISPSD, pp. 171-175, 1994. Moreover, there exist various processes for reducing the body resistance at a lower portion of the N⁺ source. The aforesaid processes are described in a paper entitled "The Insulated Gate Transistor : A New Three-Terminal MOS-Controller Bipolar Power Device", IEEE Trans. Electron device, Vol. ED-3, No. 6, pp. 821-828, June 1984, a paper entitled " Latch-back-free Self-Aligned Power MOSFET Structure with Silicided Source and Body Contact", IEEE Trans. Electron Device Lett. Vol. EDL-9, No.8, pp. 408-410, 1988, a paper entitled "SOL LIGBT Devices with a Dual P⁻ Well Implant for improved Latching Characteristics", Proc. ISPSD, pp. 254-258, 1993, and a paper entitled "Latch-up Suppressed Insulated Gate Bipolar Transistor by the Deep p⁻ Ion Implantation under the n source", Jpn. J. Appl. Phys. Vol. 33, pp. 563-565, Part 1, No. 1B, January 1994, respectively. A process for forming a highly concentrated P⁺ diffusion region in the middle of the P⁻ body region is generally used in most MOS gate type power transistors which are mass-produced. However, as it is impossible to adjust accurately the diffusion with the above process, the P⁺ diffusion region is diffused into a channel region, thereby being apt to deteriorate the forward characteristics.

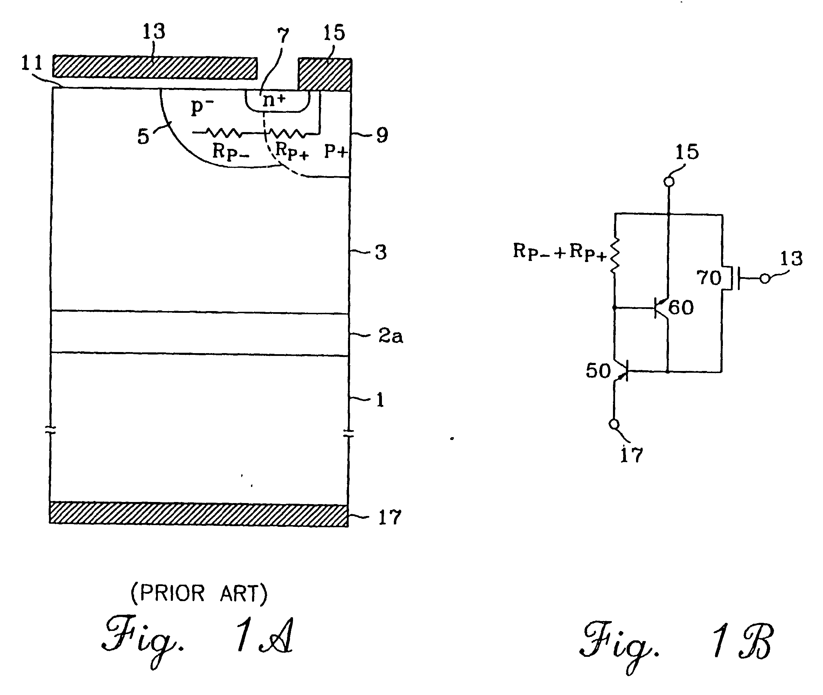

FIG. 1A is a sectional view illustrating an insulated gate bipolar transistor (IGBT) as a conventional MOS gate type power transistor which is double-diffused. In FIG. 1, an anode electrode 17 is doped with a highly concentrated P⁻ type material, serves as an accepter and is formed at a lower portion of a semiconductor substrate 1. An N⁻ buffer layer 2a is doped with a highly concentrated N⁻ type material, serves as a donor and is formed at an upper portion of the semiconductor substrate 1. A semiconductor epitaxial layer 3, for example, an N⁻ epitaxial layer is formed at an upper portion of the N⁻ buffer layer 2a.

The N' epitaxial layer 3 includes a P⁻ body region 5 diffused into the interior thereof on the surface of the upper portion thereof, an N⁺ source region 7 diffused into the P⁻ body region 5, and a highly concentrated P⁺ diffusion region 9 which is diffused through a lower portion of the N⁺ source region 7 and the P⁻ body region 5 into the epitaxial layer 3.

A gate electrode 13 and a source electrode 15, for example a cathode electrode, exist at an upper portion of the N⁻ epitaxial layer 3. The gate electrode 13 includes an insulating film 11 formed over a portion of the surface of the N⁻epitaxial layer 3, a portion of the surface of the P⁻ body region 5 and a portion of the surface of the N⁺ source region 7. The source electrode 15 covers a portion of the surface of the N⁺ source region 7 and the main surface of the P⁺ diffusion layer 9. The anode and cathode electrodes 17 and 15 are made of electrode materials such as aluminum Al and the gate electrode 13 is made of polysilicon.

As shown in FIG. 1A, the structure of the MOS gate type power transistor is equivalent to that of the IGBT as well as a lateral insulated gate bipolar transistor (LIGBT), a double MOS (DMOS), and a lateral double MOS (LDMOS).

FIG. 1B shows an equivalent circuit of FIG. 1A, which comprises a PNP transistor Q1 50, a drain 17 connected to the emitter of Q1 50, an NPN transistor Q2 60 using the base of Q1 50 as a collector, a source electrode 15 connected with the base and emitter of Q2 60, and a gate electrode 13 for connecting the emitter of Q1 50 and the source electrode 15 with the base of Q1 50. An NMOS transistor 70 is driven by applying a voltage to the gate electrode 13.

For this reason, the base of Q1 50 is activated by an electron current flow from the N' channel and a hole current applied from the drain 17 drives Q1 50. Accordingly, the electron current and the hole current flow along two paths of Q1 50, which is the NMOS transistor 70 and a PNP transistor. Thus, if the voltage drop in resistance Rₚ₋ + Rₚ₊ is over 0.7V, with an increase in the currents flowing, Q2 60 is turned on and the overall components serve as a PNPN thyristor, thus reaching the latch state where control by the gate is impossible. Consequently, it is necessary to diminish the resistance Rₚ₋ + Rₚ₊ to reduce the voltage drop in the diminished resistance region.

As stated above, since a lateral resistance Rₚ₋ always exists in the P⁻ body 5 at the lower portion of the N⁺ source 7 and the doping concentration of the P⁻ body region 5 is much lower than that of the P⁺ diffusion region 9, the lateral resistance Rₚ₋ at a lower end of the N⁺ source 7 in negligible. Therefore, the result of the lateral resistance Rₚ₋ and the lateral resistance Rₚ₊ of the P⁺ diffusion region 9 being combined is little different from the lateral resistance Rₚ₋. Thus, it is necessary to adjust very accurately the diffusion to achieve a reduction of the lateral resistance Rₚ₋. In addition, there is a disadvantage in that the size of the P⁻ body 5 may increase due to an additional mask process step.

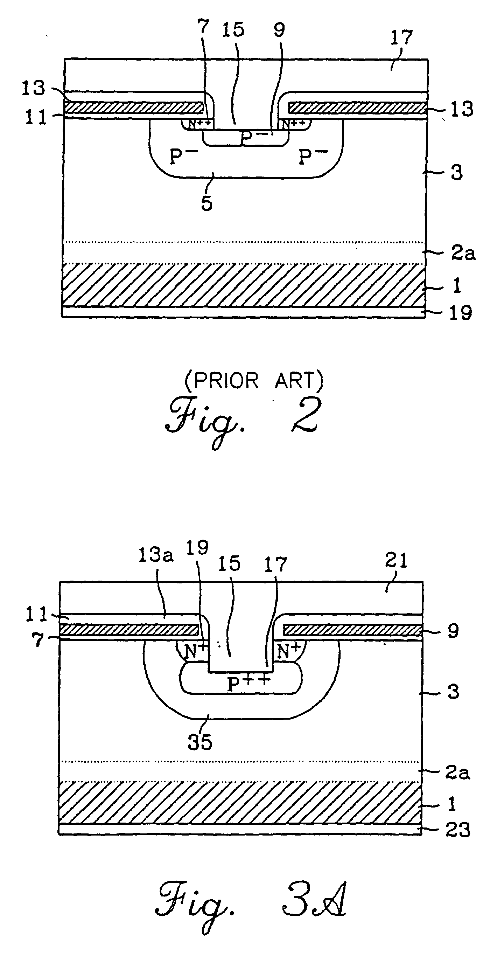

FIG. 2 is a sectional view illustrating the IGBT as a conventional trench structure MOS gate type power transistor which is double-diffused and improved in latch characteristics. FIG. 2 exhibits the improved forward characteristics of the IGBT by varying the structure of the conventional IGBT. With reference to FIG. 1, the structure of FIG. 2 is equivalent to that of FIG. 1 in terms of formation of the N⁺ source region 7. However, unlike FIG. 1, after forming the N⁺ source region 7, the trench 15 of FIG. 2 is formed in the P⁻ body region 5 through the N⁺ source region 7 and the P⁺ diffusion region 9 is formed in the P⁻ body region 5 through ion implantation of a P⁻ type dopant at a lower end of the trench 15. Thus, the size of the P⁻ body region 5 is reduced by as much as the region occupied by the trench 15, thus reducing the resistance of the P⁻ body region 5. In addition, the forward voltage drop is lowered. Besides, the length of the N⁺ source region 7 is shortened and the latch-up phenomenon is diminished due to the reduction of the lateral resistance Rp⁻ at the lower end of the N⁺ source region 7.

Recently, there has been proposed a process for preventing latch-up by upping the impurities concentration at the low end of the N⁺ source region 7 with very high energy P⁺⁺ ion implantation, by which the latch-up density of the proposed IGBT is more than five times than that of the conventional IGBT. However, an ion implanter having a very high energy of over 400KeV is required to satisfy all of the threshold voltage and the latch characteristics required. Thus, it is difficult to use the above procedure in a real process, and no improvement exists in the forward characteristics because the body size is equal to that of the body of the conventional IGBT.

Additionally, there has been proposed a process for reducing the size of the body and the length of the N⁺ source region 7 of the conventional IGBT and a metal oxide semiconductor field effect transistor (MOSFET), by which the latch feature and the forward feature are improved. Owing to shortening of the length of the body in the IGBT using a metal film spacer in which the N' type dopant is implanted, it is possible to increase the latch-up current density but it is impossible to shape the source when using high concentration of the body. Referring to FIG. 2, the trench structure 15 MOSFET and IGBT are manufacture by a process which diffuses the N⁺ source region 7, etches and ion-implants the P⁻ body 5, and makes the size of the P⁻ body region 5 small, thereby improving the forward feature. The trench structure 15 enables the concentration of the P' body region 5 at the low end of the N⁺ source region 7 to be very high. Thus, when the trench structure 15 is adapted to the IGBT, it seems that the trench structure 15 is effective in preventing the latch.

EP-A-0 342 952 (Advanced Power Technology) describes a process for manufacturing a vertical power DMOSFET comprising a recess in the source/base contact region. After having formed the p- body and implanted dopants to form the n+ source in the body, a trench is etched in the body. Thereafter, a dopant is implanted into the bottom of the trench to form the deep p+ body. One of the purposes of the deep p+ body is to limit the depth of diffusion of the n+ source during subsequent diffusion steps.

It is an object of the present invention to provide a method of manufacturing a MOS gate type power transistor having a trench body structure, for reducing the unnecessary P⁻ body region and obtaining a low forward voltage drop.

It is another object of the present invention to provide a method of manufacturing a MOS gate type power transistor having a trench body structure in which the N⁺ source region is doped with a concentration lower than that of a P⁺ region to increase the latch-up current density.

Accordingly, the present invention provides a method of forming a trench structure for a MOS gate type power transistor in a semiconductor structure which includes an epitaxial layer having a trench etched therein, the method comprising:
forming a low concentration first diffusion region by thermal predeposition of a dopant material of a first conductivity type into the trench followed by a drive-in;
forming a high concentration second diffusion region by ion implantation of a dopant material of the first conductivity type into the first diffusion region at the bottom of the trench only;
forming a third diffusion region on a sidewall of the trench by thermal predeposition of a high concentration of dopant material of a second conductivity type, the bottom of the trench remaining of the first conductivity type; and
subsequently performing thermal diffusion to widen the second and third diffusion regions simultaneously resulting in the second diffusion region contacting and spanning the bottom of the third diffusion region during the thermal diffusion process.

Preferably, the said semiconductor structure is formed as follows:
forming a semiconductor epitaxial layer on a semiconductor substrate of a first conductivity type;
forming a first insulating film on the epitaxial layer;
forming a gate electrode on the first insulating film;
forming a second insulating film on the gate electrode;
etching a medial region of the second insulating film and the gate electrode;
forming a third insulating film over the etched medial region;
etching the third insulating film to form a spacer on either side of the etched medial region; and
vertically etching the semiconductor epitaxial layer using the spacer as a mask to form the trench.

More preferably, the formation of said semiconductor structure may comprise the further steps of:
forming a first electrode extending from within the trench to the second insulating film to electrically connect the second and third diffusion regions; and
forming a second electrode on the underside of the semiconductor substrate to form a MOS-gate type power transistor.

Alternatively, the formation of said semiconductor structure may comprise the further steps of:
forming a trench structure employing a method as described above as being in accordance with the invention wherein an insulating layer is formed on the semiconductor substrate and the semiconductor epitaxial layer is formed on that insulating layer;
etching the first and second insulating films and the gate electrode at a position separated from the trench structure;
forming a fourth diffusion region by ion implantation of a conductive material of the first conductivity type into the semiconductor epitaxial layer at the etched position; and
forming a second electrode over the fourth diffusion region, to form a MOS gate type power transistor.

Preferably, the first conductivity type is P-type and the second conductivity type is N-type, the first insulating film is a silicon oxide layer, the second insulating film is a silicon nitride film and the gate electrode is formed from polycrystalline silicon.

Preferably, the semiconductor substrate is of the first conductivity type and the semiconductor epitaxial layer is of the second conductivity type.

A more complete appreciation of this invention, and many of the attendant advantages thereof, will be readily apparent as the same becomes better understood by reference to the following detailed description when considered in conjunction with the accompanying drawings, in which like reference symbols indicate the same or similar elements devices, wherein:
FIG. 1A is a sectional view illustrating an IGBT as a conventional MOS gate type power transistor which is double-diffused;
FIG. 1B shows an equivalent circuit of FIG. 1A;
FIG. 2 is a sectional view illustrating an IGBT as a conventional trench structure MOS gate type power transistor which is double-diffused and improved in latch characteristics;
FIG. 3A is a sectional view illustrating an IGBT as a trench structure MOS gate type power transistor which is double-diffused and improved in low forward voltage drop and high latch current density as obtained by the present invention;
FIG. 3B shows process steps of FIG. 3A according to one embodiment of the present invention;
FIG. 3C shows process steps of FIG. 3A according to another embodiment of the present invention;
FIG. 4 shows a simulated current-voltage I-V characteristics curve illustrating a conventional IGBT and the IGBT as obtained by the present invention;
FIG. 5 shows latch-up current densities I and the forward current densities I at a forward voltage drop of 2V in accordance with variation of the phosphorous surface peak concentration of the N⁺ source of the IGBT as obtained by the present invention; and
FIG. 6 shows variations of threshold voltages V and latch-up current densities I in accordance with variation of the driven-in times T of the N⁺ source and a P⁺⁺ body of the IGBT as obtained by the present invention.

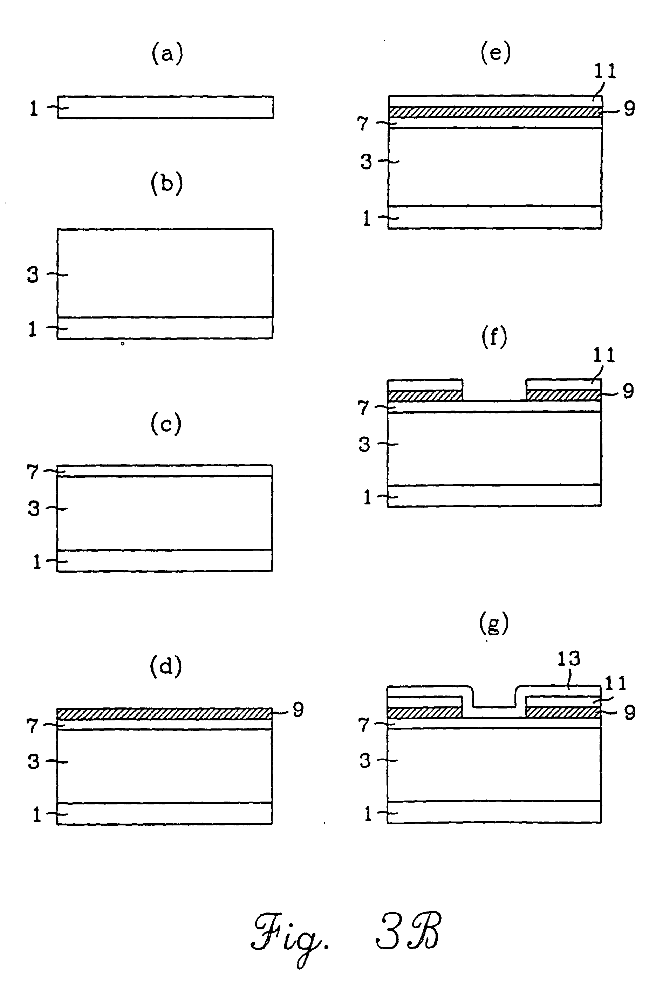

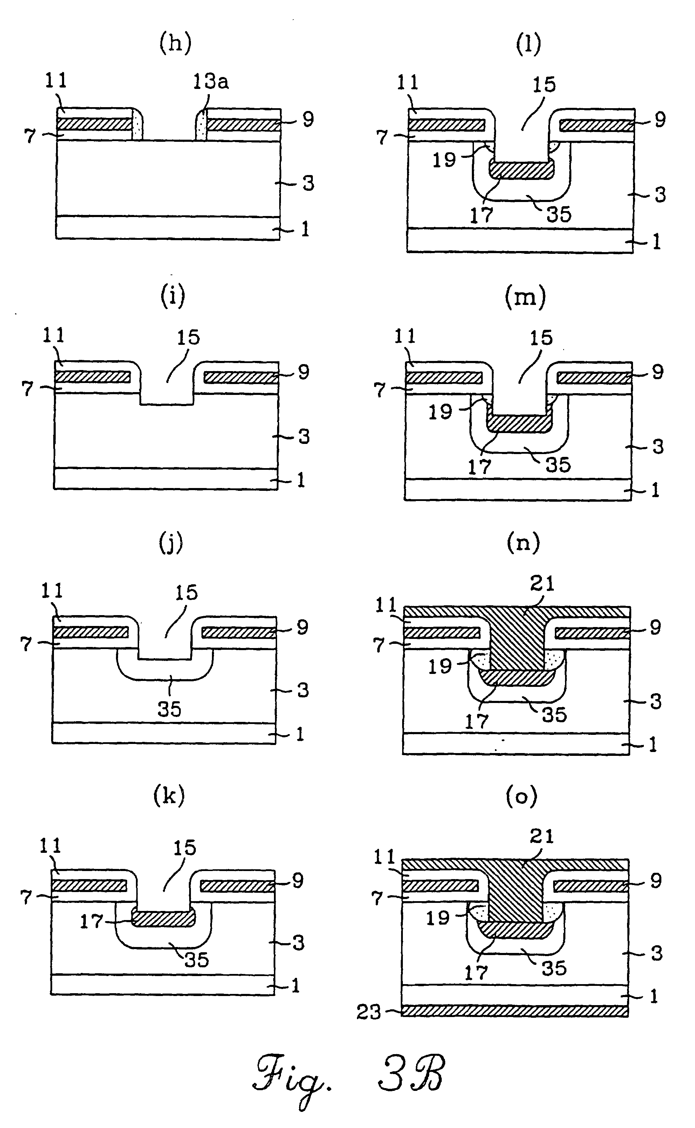

Preferred embodiments of a MOS gate type power transistor as obtained by the present invention now be described with reference to FIGs. 3A, 3B and 3C.

FIG. 3A is a sectional view illustrating an IGBT as a trench structure MOS gate type power transistor which is double-diffused and improved in low forward voltage drop and high latch current density as obtained by the present invention and FIG. 3B shows the construction of FIG. 3A, illustrating process steps in the manufacture of the IGBT.

Referring to FIG. 3B, the process for manufacturing the IGBT which has a small source and a low emitter efficiency, comprises the following steps: (a) preparing a P⁺ type semiconductor substrate 1; (b) forming an N⁻ epitaxial layer 3 on the surface of the P⁺ type semiconductor substrate 1; (c) thermally growing a gate oxide layer 7 7 on the main surface of the N⁻ epitaxial layer 3 to a thickness of approximately 100 nm (1,000 angstroms;) (d) depositing a polycrystaline silicon 9 to be used as the gate electrode at the surface of the gate active layer 7; (e) performing a POCL₃ doping process to lower the gate resistance over the upper surface and depositing a silicon nitride film Si₃N₄ 11; (f) performing a photolithographic etching process and an anisotropic etching process a reactive ion etching; (g) depositing a silicon nitride film 13 on the overall surface; (h) forming a nitride film spacer 13a with an anisotropic etching process; (i) using the nitride film spacer 13a as a mask, anisotropically etching the N⁻ epitaxial layer 3, and shaping a trench structure 15; (j) predepositing boron as a dopant at temperature of900°C into the N⁻ epitaxial layer 3 through the trench 15 for 70 minutes, performing a drive-in process for the boron at a temperature of 1150°C for 500 minutes, and forming a low concentration P' body region 35; (k) performing boron ion implantation with energy of more or less 20KeV and a dose range from 1×10¹⁵-1×10¹⁶cm⁻² so as to form the high concentration P⁺⁺ body region 14 without masks, wherein boron atom are implanted at the bottom, not at the sidewall of the trench 15 because of the vertical incidence of the ion implantation and performing a drive-in process for the boron at a temperature of 1100°C for 500 minutes; (1) performing thermal predeposition of phosphorous at a temperature of about 900°C without masks for 20 minutes so as to form a low concentration N⁻ type source region 19 at the sidewall of the trench 15; (m) simultaneously performing the drive-in process of the phosphorous and the boron at temperature of 1050°C for 90-150 minutes, wherein the phosphorous atoms diffuse laterally into the silicon to form an N⁻ source region 19 only at the upper portion of the trench 15 and not at the bottom of the trench 15 due to the doping concentration difference between the P⁻ body region 35 and the P⁺⁺ body region 17, and as both of the phosphorous and the boron atoms are diffused simultaneously, the area under the N⁻ source is always occupied by the heavily concentrated boron region regardless of the diffusion time; (n) after the aforesaid 5 diffusion process, performing a photolithographic etching process of a gate contact window, performing vapour deposition and drive-in processes of aluminum 21, etching and annealing the aluminum, performing a photolithographic etching process of a photosensitive film using a metal mask and etching the aluminum 21; and (o) vapour depositing the aluminum 21 on the lower surface of the semiconductor substrate 1 and forming an anode electrode.

FIG. 3C shows a lateral insulated gate bipolar transistor (LIGBT) of FIG. 3A as obtained by another embodiment of the present invention.

While FIG. 3C is similar to FIG. 3B, FIG. 3C is different from FIG. 3B in that the anode electrode in FIG. 3C is formed on the vertical surface. Therefore, the LIGBT also has the above structure as obtained by the present invention.

A process of manufacturing the LIGBT of FIG. 3C will now be described, comprising the steps of: (a) vapour depositing an insulating layer 25 made of a silicon active layer on the surface of the P⁻ type semiconductor substrate 1; (b) forming the N⁻ epitaxial layer 3, for example, an N' type silicon at the upper surface of the insulating layer 25; (c) thermally growing a gate active layer 7 on the upper surface of the N⁻ epitaxial layer 3 to a thickness of approximately 100 nm (1,000 angstroms); (d) depositing the polycrystaline silicon 9 to be used as the gate electrode; (e) performing the POCL₃ doping process to lower the gate resistance and depositing the silicon nitride film Si₃N₄ 11; (f) performing the photolithographic etching process and the anisotropic etching process with reactive ion etching; (g) vapour depositing a silicon nitride film 13; (h) forming a nitride film spacer 13a with an anisotropic etching process; (i) using the nitride film spacer 13a as a mask, anisotropically etching the N₋ epitaxial layer 3 and shaping a trench structure 15; (j) predepositing boron as a dopant at a temperature of 900°C into the N⁻ epitaxial layer 3 through the trench 15 for 70 minutes, performing the drive-in process for the boron at a temperature of 1150°C for 500 minutes, and forming a low concentration P⁻ body region 35; (k) performing the thermal diffusion of the boron for the P⁻ body region 35 at temperature of 1100°C for 500 minutes and performing boron ion implantation with energy of more or less 20KeV and a dose range from 1×10¹⁵-1×10¹⁶cm⁻² so as to form the highly concentrated P⁺⁺ body region 14 without masks, wherein boron atom are implanted at the bottom, not at the sidewall of the trench 15 because of the vertical incidence of the ion implantation; (l) performing thermal predeposition of phosphorous at a temperature of about 900°C without masks for 20 minutes so as to form a low concentration N⁻ type source region 19 at the sidewall of the trench 15; (m) simultaneously performing the drive-in process of the phosphorous and the boron at a temperature of 1050°C for 90-150 minutes, wherein the phosphorous atoms diffuse laterally into silicon to form N⁻ source region 19 only at the upper portion of the trench 15 not at the bottom of the trench 15 due to the doping concentration difference between the P⁻ body region 35 and the P⁺⁺ body region 17, and as both of the phosphorous and the boron atoms are diffused simultaneously, the area under the N⁻ source is always occupied by the heavily concentrated boron region regardless of diffusion time; (n) after the aforesaid diffusion process, performing the photolithographic etching process of a gate contact window, performing the vapour deposition and the annealing process of the aluminum 21, etching and performing a drive-in process for the aluminum, performing the photolithographic etching process of a photosensitive film by using a metal mask and etching the aluminum 21; and (o) etching the silicon nitride film 11 and the gate active layer 7 at the upper surface separated by a given distance from the P⁻ body region 35, shaping an anode electrode window 24, and forming a P⁻ type diffusion region 22 from boron in the interior of the N' epitaxial layer 3, vapour depositing the aluminum 21 at the lower surface of the semiconductor substrate 1 and forming an anode electrode.

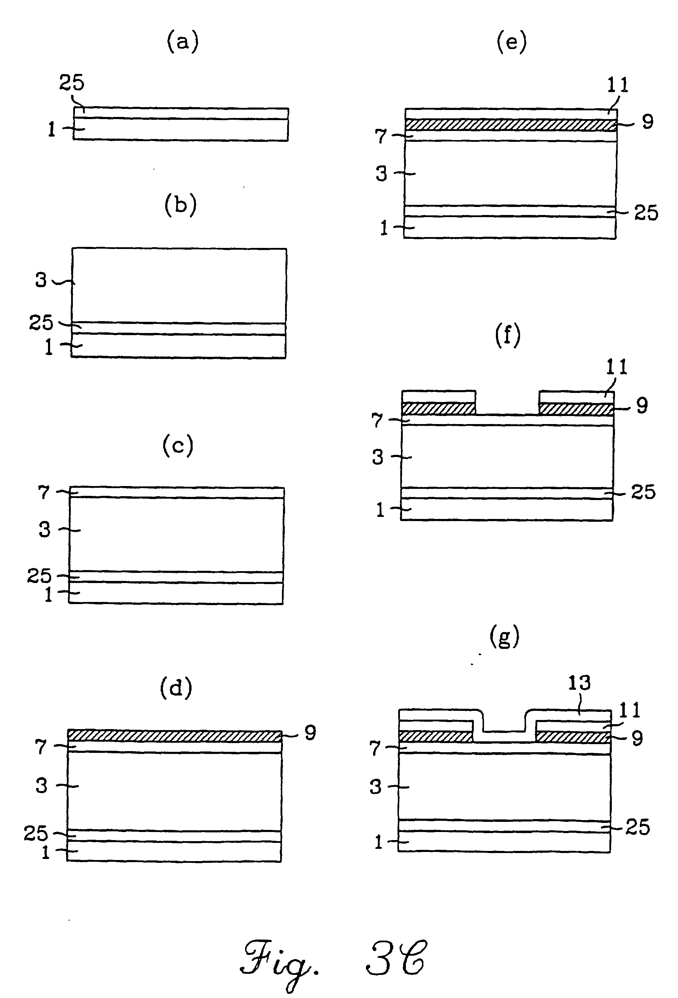

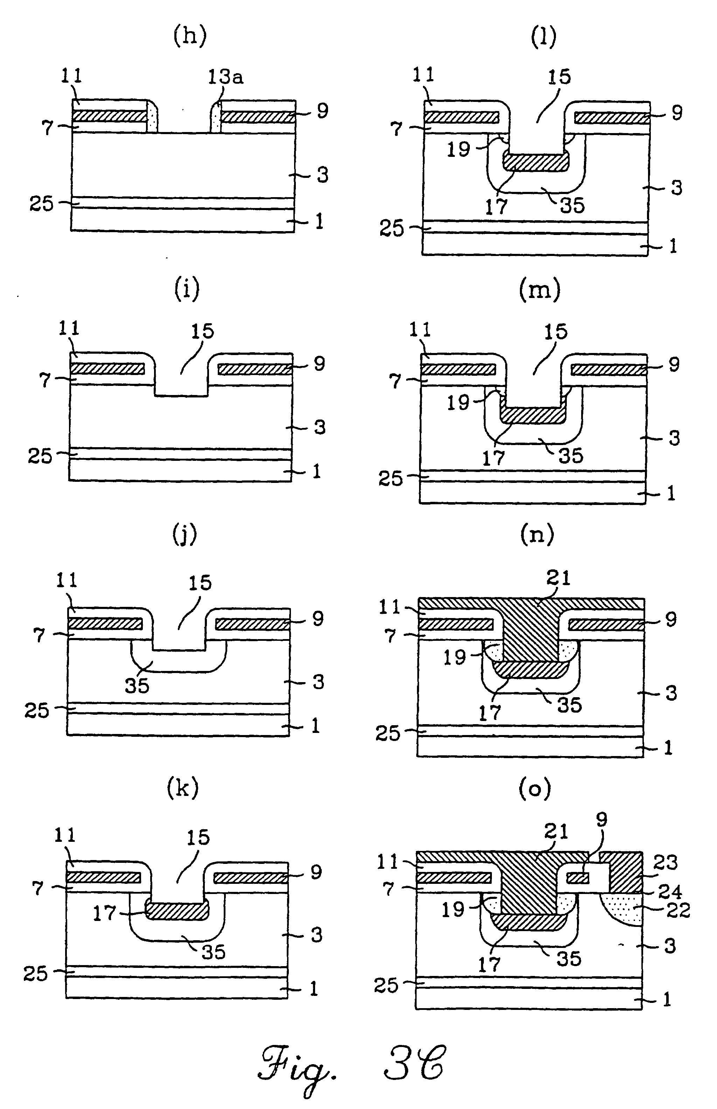

FIGs. 4 to 6 shows the simulated results of the electrical characteristics of the IGBT as obtained by the present invention.

FIG. 4 shows a simulated current-voltage I-V characteristics curve illustrating a conventional IGBT and the IGBT as obtained by the present invention.

In such a case, the ion-implantation dose for the P⁺⁺ region is identical to 5×10¹⁵cm⁻², which is equal to that of the conventional IGBT. Latch-up occurs at a current density of 9000 A/cm² for the IGBT according to the present invention while it occurs at a current density of about 2000 A/cm² for the conventional IGBTs. Thus the latch current density is improved more than four times compared with that of the conventional IGBT.

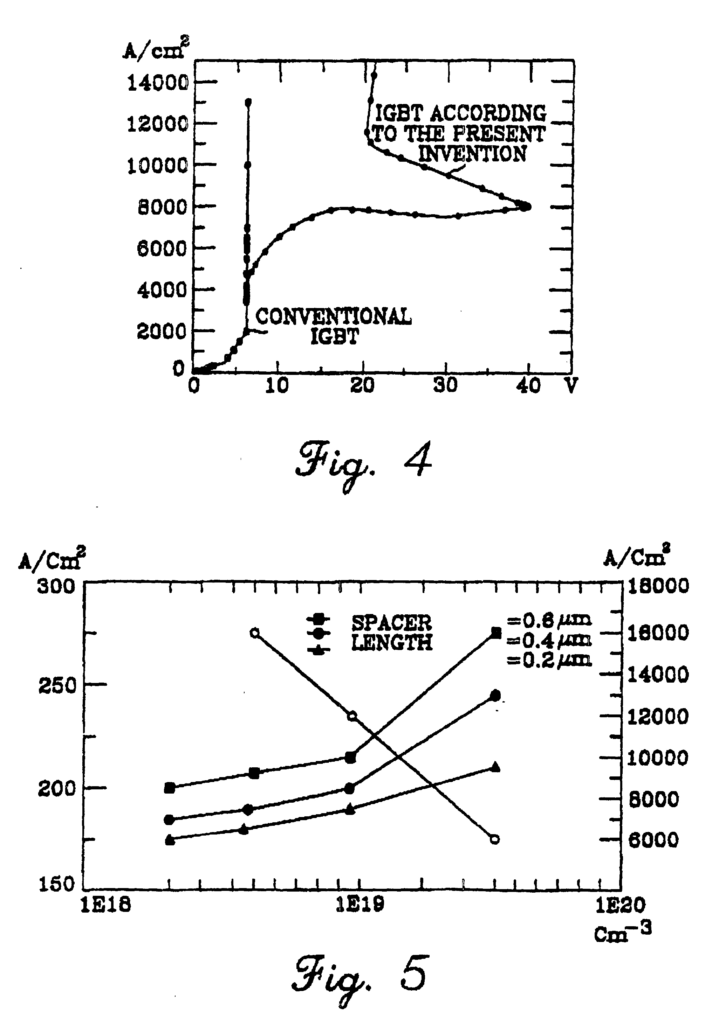

FIG. 5 shows latch-up current densities I and forward current densities I at a forward voltage drop of 2V in accordance with variation of the phosphorous surface peak concentration of the N⁺ source of the IGBT. As can be seen in FIG. 5, the current density is 6000 A/cm₂ when the phosphorous concentration is 4×10¹⁹cm⁻². Thus, as the phosphorous concentration decreases, the latch current density is steadily increased. Also, the latch does not occur with the doping phosphorous concentration below 5×10¹⁸cm⁻². No latch-up with low phosphorous concentration may be explained as follows. Firstly, the emitter is formed to be so small that the P' body resistance under the emitter may be negligible. Secondly, the emitter efficiency of the parasitic NPN bipolar transistor is decreased due to a decrease in the emitter doping concentration. The effect of phosphorous concentration on the forward current density at the forward voltage drop of 2V is observable with variation of the forward current density of the IGBTs.

As shown in FIG. 5, it appears that the forward current density decreases slightly with decreases of the phosphorous concentration. That is, as the phosphorous concentration decreases, the size of the source is reduced vertically, the length of the channel is increased and P⁻ polarity concentration in the channel region increases, thus contributing to an increase in the threshold voltage.

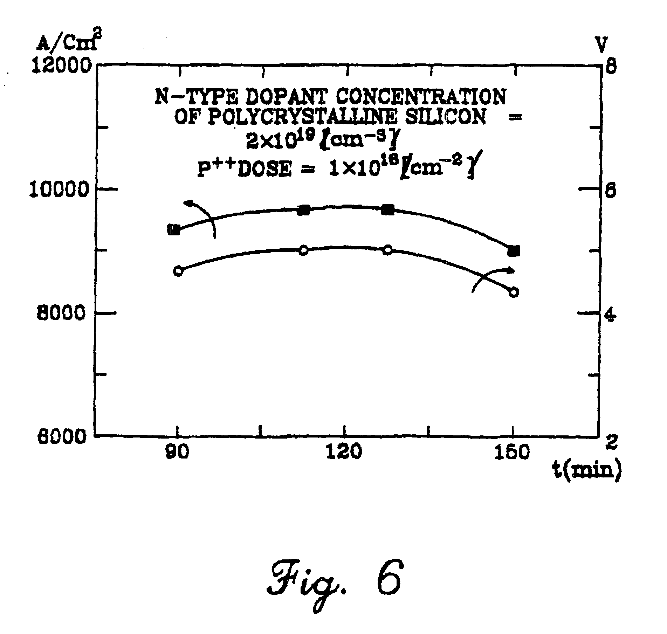

FIG. 6 shows variations of threshold voltages V and latch-up current densities I in accordance with variations of the drive-in times T of the N⁺ source and a P⁺⁺ body of the IGBT as obtained by the present invention.

In the simulations, the temperature is 1150°C, the implanted dose of the boron for the P⁺⁺ body is 5×10¹⁸cm⁻² and the surface peak concentration of the N⁺ source is 2×10¹⁹cm⁻². As the diffusion time varies from 90 minutes to 150 minutes, it appears that the threshold density and the latch-up current density vary from 4.4V to 4.1V and from 9000 A/cm² to 9800 A/cm², respectively. The little effects of the diffusion time on the latch-up characteristics can be explained in that the N⁺ emitter and the P⁺⁺ region extend simultaneously so that the whole area under the N⁺ emitter is covered by high concentrated boron and the channel region is not affected. Therefore, no increase in the body resistance is caused by increasing the length of the source.

Using the method of the present invention, an IGBT is provided in which the trench structure is formed in the middle of the P⁻ body region, the N₊ source is diffused into the sidewall of the trench 15 and the source is of a small size. Because the IGBT requires no high concentration P⁺ diffusion region, the source and the body contact window, the IGBT enables the size of the body to be small, thus improving the current density. As the concentration of the source is lower than that of the P⁺ body region, the parasite NPN transistor can have low emitter efficiency and latch up current densities of over 10000 A/cm², not being influenced by variations of the process conditions.

Therefore, it has been shown that the IGBT has achieved high latch-up current density and low on state voltage drop. The structure of the IGBT may be adapted to a power MOSFET, DOMOS or LDMOS.

## Claims

1. A method of forming a trench structure for a MOS gate type power transistor in a semiconductor structure which includes an epitaxial layer (3) having a trench (15) etched therein, the method comprising:
forming a low concentration first diffusion region (35) by thermal predeposition of a dopant material of a first conductivity type into the trench followed by a drive-in;
forming a high concentration second diffusion region (17) by ion implantation of a dopant material of the first conductivity type into the first diffusion region (35) at the bottom of the trench only;
forming a third diffusion region (19) on a sidewall of the trench by thermal predeposition of a high concentration of dopant material of a second conductivity type, the bottom of the trench remaining of the first conductivity type; and
subsequently performing thermal diffusion to widen the second and third diffusion regions simultaneously resulting in the second diffusion region contacting and spanning the bottom of the third diffusion region during the thermal diffusion process.

2. A method according to claim 1 including forming the said semiconductor structure as follows:
forming a semiconductor epitaxial layer (3) on a semiconductor substrate of a first conductivity type;
forming a first insulating film (7) on the epitaxial layer;
forming a gate electrode (9) on the first insulating film;
forming a second insulating film (11) on the gate electrode;
etching a medial region of the second insulating film and the gate electrode;
forming a third insulating film (13) over the etched medial region;
etching the third insulating film to form a spacer (13a) on either side of the etched medial region; and
vertically etching the semiconductor epitaxial layer using the spacer as a mask to form the trench (15).

3. A method according to claim 2, further comprising:
forming a first electrode (21) extending from within the trench to the second insulating (11) film to electrically connect the second (17) and third (19) diffusion regions; and
forming a second electrode (23) on the underside of the semiconductor substrate, to form a MOS gate type power transistor.

4. A method according to claim 2, wherein an insulating layer (25) is formed on the semiconductor substrate and the semiconductor epitaxial layer is formed on that insulating layer, the method further comprising:
etching the first (7) and second (11) insulating films and the gate electrode at a position separated from the trench structure;
forming a fourth diffusion (22) region by ion implantation of a dopant material of the first conductivity type into the semiconductor epitaxial layer (3) at the etched position; and
forming a second electrode (23) over the fourth diffusion region (22), to form a MOS gate type power transistor.

5. A method according to any preceding claim in which the first conductivity type is P-type and the second conductivity type is N-type, the first insulating film (7) is a silicon oxide layer, the second insulating film (9) is a silicon nitride film and the gate electrode (9) is formed from polycrystalline silicon.

6. A method according to any preceding claim in which the semiconductor substrate is of the first conductivity type and the semiconductor epitaxial layer is of the second conductivity type.

## Patentansprüche

1. Verfahren zur Herstellung einer Grabenstruktur für einen Leistungstransistor vom MOS-Gate-Typ in einer Halbleiterstruktur, die eine epitaktische Schicht (3) mit einem darin geätzten Graben (15) aufweist, wobei das Verfahren umfaßt:
Bilden einer ersten Diffusionsregion (35) niedriger Konzentration durch thermische Vorablagerung eines Dotiermaterials eines ersten Leitfähigkeitstyps in dem Graben gefolgt von einer Eindiffusion,
Bilden einer zweiten Diffusionsregion (17) hoher Konzentration ausschließlich am Boden des Grabens durch Ionenimplantation eines Dotiermaterials des ersten Leitfähigkeitstyps in die erste Diffusionsregion (35),
Bilden einer dritten Diffusionsregion (19) an einer Seitenwand des Grabens durch thermische Vorablagerung einer hohen Konzentration von Dotiermaterial eines zweiten Leitfähigkeitstyps, wobei der Boden des Grabens vom ersten Leitfähigkeitstyp bleibt, und
anschließendes Durchführen von thermischer Diffusion, um die zweiten und dritten Diffusionsregionen gleichzeitig auszuweiten, was dazu führt, daß die zweite Diffusionsregion den Boden der dritten Diffusionsregion während des thermischen Diffusionsprozesses kontaktiert und überspannt.

2. Verfahren nach Anspruch 1, das die Bildung der Halbleiterstruktur in folgender Weise umfaßt:
Bilden einer epitaktischen Halbleiterschicht (3) auf einem Halbleitersubstrat eines ersten Leitfähigkeitstyps,
Bilden einer Isolierschicht (7) auf der epitaktischen Schicht,
Bilden einer Gate-Elektrode (9) auf der ersten Isolierschicht,
Bilden einer zweiten Isolierschicht (11) auf der Gate-Elektrode,
Ätzen eines mittleren Bereichs der zweiten Isolierschicht und der Gate-Elektrode,
Bilden einer dritten Isolierschicht (13) über dem geätzten Mittelbereich,
Ätzen der dritten Isolierschicht, um eine Distanzzone (13a) auf beiden Seiten des geätzten mittleren Bereichs zu bilden und,
vertikales Ätzen der epitaktischen Halbleiterschicht unter Verwendung der Distanzzonen als Maske zur Bildung des Grabens (15).

3. Verfahren nach Anspruch 2, das weiter aufweist:
Bilden einer ersten Elektrode (21), die von innerhalb des Grabens zu der zweiten Isolierschicht verläuft, um die zweite (17) und dritte (19) Diffusionsregion elektrisch zu verbinden, und
Bilden einer zweiten Elektrode (23) auf der Unterseite des Halbleitersubstrats, um einen Leistungstransistor vom MOS-Gate-Typ zu bilden.

4. Verfahren nach Anspruch 2, wobei eine Isolierschicht (25) auf dem Halbleitersubstrat gebildet wird und die epitaktische Halbleiterschicht auf der Isolierschicht gebildet wird, wobei das Verfahren weiter umfaßt:
Ätzen der ersten (17) und zweiten (11) Isolierschichten und der Gate-Elektrode an einer von der Grabenstruktur getrennten Position,
Bilden einer vierten Diffusionsregion (22) durch Ionenimplantation eines Dotiermaterials des ersten Leitfähigkeitstyps in die epitaktische Halbleiterschicht (3) an der geätzten Stelle, und
Bilden einer zweiten Elektrode (23) über der vierten Diffusionsregion (22), um einen Leistungstransistor von MOS-Gate-Typ zu bilden.

5. Verfahren nach einem der vorhergehenden Ansprüche, bei dem der erste Leitfähigkeitstyp der P-Typ und der zweite Leitfähigkeitstyp der N-Typ ist, die erste Isolierschicht (17) eine Siliciumoxidschicht ist, die zweite Isolierschicht (19) eine Siliciumnitridschicht und die Gate-Elektrode (19) aus polikristallinem Silicium gebildet ist.

6. Verfahren nach einem der vorhergehenden Ansprüche, bei dem das Halbleitersubstrat vom ersten Leitfähigkeitstyp ist und die epitaktische Halbleiterschicht vom zweiten Leitfähigkeitstyp ist.

## Revendications

1. Méthode de formation d'une structure en tranchée pour un transistor de puissance à porte MOS dans une structure semi-conductrice qui inclut une couche épitaxiale (3) ayant une tranchée (15) gravée en son sein, la méthode comprenant :
La formation d'une première région de diffusion à faible concentration (35) par prédéposition thermique d'une substance dopante d'un premier type de conductivité dans la tranchée suivie par une redistribution;
La formation d'une seconde région de diffusion à haute concentration (17) par implantation ionique d'une substance dopante du premier type de conductivité dans la première région de diffusion (35), dans le fond de la tranchée uniquement;
La formation d'une troisième région de diffusion (19) sur une contre-paroi par prédéposition thermique d'une substance dopante à haute concentration d'un second type de conductivité, le fond de la tranchée restant du premier type de conductivité ; et
Par la suite, la réalisation d'une diffusion thermique pour élargir les seconde et troisième régions de diffusion simultanément, conduisant à la mise en contact et à l'enjambement du fond de la troisième région de diffusion par la seconde région de diffusion durant le procédé de diffusion thermique.

2. Méthode selon la revendication 1, **caractérisée en ce qu'**elle inclut la formation de ladite structure semi-conductrice comme suit :
La formation d'une couche épitaxiale semi-conductrice (3) sur un substrat semi-conducteur d'un premier type de conductivité ;
La formation d'un premier film isolant (7) sur la couche épitaxiale ;
La formation d'une électrode grille (9) sur le premier film isolant ;
La formation d'un second film isolant (11) sur l'électrode grille;
La gravure d'une région médiane sur le second film isolant et l'électrode grille;
La formation d'un troisième film isolant (13) au dessus de la région médiane gravée;
La gravure d'un troisième film isolant pour former une entretoise (13a) sur l'un des côtés de la région médiane gravée; et
La gravure de façon verticale de la couche épitaxiale semi-conductrice en utilisant l'entretoise comme un masque pour former la tranchée (15).

3. Méthode selon la revendication 2, **caractérisée en ce qu'**elle comprend de plus :
La formation d'une première électrode (21) s'étendant à partir de l'intérieur de la tranchée vers le second film isolant (11) pour connecter électriquement les seconde (17) et troisième (19) régions de diffusion ; et
La formation d'une seconde électrode (23) sur le dessous du substrat semi-conducteur, pour former un transistor de puissance à porte MOS.

4. Méthode selon la revendication 2, **caractérisée en ce qu'**une couche isolante (25) est formée sur le substrat semi-conducteur et **en ce que** la couche épitaxiale semi-conductrice est formée sur cette couche isolante, la méthode comprenant de plus :
La gravure des premier (7) et second (11) films isolants et d'une électrode grille sur un emplacement séparé de la structure en tranchée.
La formation d'une quatrième région de diffusion (22) par implantation ionique d'une substance dopante du premier type de conductivité dans la couche épitaxiale semi-conductrice (3) sur la position gravée; et
La formation d'une seconde électrode (23) sur la quatrième région de diffusion (22) pour former un transistor de puissance à porte MOS.

5. Méthode selon l'une des revendications précédentes, **caractérisée en ce que** le premier type de conductivité est de type P et **en ce que** le second type de conductivité est de type N, le premier film isolant (7) est une couche d'oxyde de silicium, le second film isolant (11) est un film de nitrure de silicium et l'électrode grille (9) est formée à partir de silicium polycristallin.

6. Méthode selon l'une des revendications précédentes, **caractérisée en ce que** le substrat semi-conducteur est du premier type de conductivité et la couche épitaxiale semi-conductrice est du second type de conductivité.
